(19) Europäisches Patentamt / European Patent Office / Office européen des brevets

(11) **EP 4 066 071 B1**

(12) **EUROPÄISCHE PATENTSCHRIFT**

(45) Veröffentlichungstag und Bekanntmachung des Hinweises auf die Patenterteilung:
**02.10.2024 Patentblatt 2024/40**

(21) Anmeldenummer: **20839103.7**

(22) Anmeldetag: **24.12.2020**

(51) Internationale Patentklassifikation (IPC):
***H04L 41/14*** *(2022.01)*

(52) Gemeinsame Patentklassifikation (CPC):
**H04L 41/145; G05B 17/02**

(86) Internationale Anmeldenummer:
**PCT/EP2020/087887**

(87) Internationale Veröffentlichungsnummer:
**WO 2021/136749 (08.07.2021 Gazette 2021/27)**

(54) **VERFAHREN UND SYSTEM ZUR PARAMETRIERUNG EINES ANLAGENMODELLS**

METHOD AND SYSTEM FOR ADJUSTING THE PARAMETERS OF A SYSTEM MODEL

PROCÉDÉ ET SYSTÈME DE PARAMÉTRISATION D'UN MODÈLE D'INSTALLATION

(84) Benannte Vertragsstaaten:
**AL AT BE BG CH CY CZ DE DK EE ES FI FR GB GR HR HU IE IS IT LI LT LU LV MC MK MT NL NO PL PT RO RS SE SI SK SM TR**

(30) Priorität: **30.12.2019 EP 19220049**

(43) Veröffentlichungstag der Anmeldung:
**05.10.2022 Patentblatt 2022/40**

(73) Patentinhaber: **Siemens Aktiengesellschaft 80333 München (DE)**

(72) Erfinder:
• **METTENLEITER, Manuel 91056 Erlangen (DE)**
• **HÖHLEIN, Nicolai 90409 Nürnberg (DE)**

(74) Vertreter: **Siemens Patent Attorneys Postfach 22 16 34 80506 München (DE)**

(56) Entgegenhaltungen:
EP-A1- 3 521 947      WO-A1-2014/187828
DE-A1- 102017 204 173   DE-A5- 112005 001 710

**Beschreibung**

Verfahren und System zur Parametrierung eines Anlagenmodells Die vorliegende Erfindung betrifft ein Verfahren und ein System zur Parametrierung eines Anlagenmodells.

Simulationen von Prozessen spielen z. B. in der Anlagenplanung, aber auch im Anlagenbetrieb eine zunehmend größere Rolle. Dabei sind für verschiedene Anwendungsfälle (Use Cases) unterschiedliche Simulationsansätze bekannt: physikalische Modelle beschreiben die Anlage, insbesondere die verschiedenen Anlagenkomponenten, mithilfe von Gleichungen, die auf physikalischen Gesetzen, wie zum Beispiel Erhaltungssätzen basieren. Solche Modelle sind oftmals komplex. Zum Beispiel enthalten solche Modelle eine Vielzahl von Parametern, die zur Verwendung des Modells im Rahmen der Simulation der Anlage sorgfältig eingestellt werden müssen.

Sogenannte "Blackbox"-Modelle beschränken sich dagegen auf die Nachbildung des Ein- und Ausgangsverhaltens der Anlagenkomponenten, ohne physikalische Zusammenhänge bzw. die beschreibenden Gleichungen im Detail nachzubilden. Bei phänomenologischen Modellen, einer Variante der "Blackbox"-Modelle, werden z. B. die physikalischen Zusammenhänge auf ihre zentrale Dynamik reduziert, sodass nur wenige Kenngrößen zur Skalierung der Modelle einstellbar sind. Andere Ansätze nutzen künstliche Intelligenz, um mit Hilfe von vorhandenen Daten zu dem gewünschten Ein- und Ausgangsverhalten zu gelangen. Trotz gewissen Vorteilen von "Blackbox"-Modellen gegenüber physikalischen Modellen bleibt andererseits der Nachteil, dass diese nicht die gleiche Präzision liefert bzw. nur das mit vorhandenen Daten gelernte Verhalten nachbilden können.

EP 3521 947 A1 offenbart ein Verfahren zum Ermitteln eines Prognosewertes einer zeitabhängigen Ausgangsgröße, insbesondere zur Regelung oder Steuerung eines Energiesystems, für einen Prognosezeitpunkt. Das Verfahren umfasst wenigstens folgende Schritte:- Bereitstellen von Werten der zeitabhängigen Ausgangsgröße für in Bezug auf den Prognosezeitpunkt vergangene Zeitpunkte;-Bereitstellen von Werten wenigstens einer zeitabhängigen Eingangsgröße für den Prognosezeitpunkt und/oder für in Bezug auf den Prognosezeitpunkt vergangene Zeitpunkte;- Festlegen eines mathematischen Modells mittels einer Mehrzahl von Modellparametern, mittels der Eingangsgröße und/oder mittels der Ausgangsgröße, sowie mittels einer Mehrzahl von Binärvariablen; wobei- den Werten der Eingangsgröße und den Werten der Ausgangsgröße jeweils eine der Binärvariablen derart zugeordnet wird, dass der zugehörige Wert der Eingangsgröße oder der zugehörige Wert der Ausgangsgröße zum mathematischen Modell beiträgt, falls die zugeordnete Binärvariable den Wert Eins aufweist; und- Minimieren eines Modellfehlers des mathematischen Modells, wobei durch das Minimieren der Prognosewert der Ausgangsgröße berechnet, sowie die Werte der Modellparameter und die Werte der Binärvariablen ermittelt werden.Weiterhin betrifft die Erfindung ein Energiemanagementsystem.

Es ist eine Aufgabe der Erfindung, die Anwendung von Anlagenmodellen zu vereinfachen.

Diese Aufgabe wird gelöst durch ein Verfahren und ein System zur Parametrierung eines Anlagenmodells gemäß den unabhängigen Ansprüchen.

Bei einem, insbesondere computerimplementierten, Verfahren zur Parametrierung eines Anlagenmodells gemäß einem ersten Aspekt der Erfindung wird ein Modell oder Teilmodell einer Anlage aus einer oder mehreren Modellkomponenten, die physikalische Teilprozesse des Anlagenprozesses abbilden, bereitgestellt und wenigstens ein Ausgangsgrößenwert in einem Arbeitspunkt der Anlage vorgegeben. Zudem werden Eingangsgrößenwerte und/oder Parameterwerte und/oder weitere Ausgangsgrößenwerte der Teilprozesse auf Grundlage der Modellkomponenten und des wenigstens einen vorgegebenen Ausgangsgrößenwerts ermittelt.

Ein Anlagenmodell im Sinne der Erfindung ist hierbei insbesondere ein Modell oder Teilmodell einer industriellen Anlage, z. B. einer verfahrenstechnischen oder fertigungstechnischen Anlage. Das Anlagenmodell bildet vorzugsweise einen Anlagenprozess oder Teilprozess ab und umfasst einen oder mehrere Modellkomponenten, die prozess- oder verfahrenstechnisch beliebig miteinander verbunden sein können. Somit können Eingangsgrößenwerte eines Anlagenprozesses oder Teilprozesses die Ausgangsgrößenwerte eines anderen Anlagenprozesses oder Teilprozesses sein und diese wiederum die Eingangsgrößenwerte eines weiteren Anlagenprozesses oder Teilprozesses. Das Anlagenmodell liefert auf Grundlage von Eingangsgrößenwerten, etwa eines Massenstroms, somit zum Beispiel Werte für Ausgangsgrößen, etwa eine Ausgangsleistung. Das Anlagenmodell ist vorzugsweise parametrisiert, wobei Prozessbedingungen zum Beispiel durch die Wahl der (Prozess-)Parameter bzw. Prozessgrößen festgelegt werden können. Solche Parameter bzw. Prozessgrößen können zum Beispiel Temperaturen, Drücke, Ventilstellungen, Eingangsleistungen und/oder dergleichen sein.

Ein Aspekt der Erfindung basiert auf dem Ansatz, Eingangsgrößenwerte und/oder Parameterwerte und/oder weitere Ausgangsgrößenwerte für durch Modellkomponenten abbildbare Teilprozesse eines zu simulierenden Anlagenprozesses automatisch zu ermitteln. Dazu gibt ein Benutzer vorzugsweise wenigstens einen Ausgangsgrößenwert des Anlagenprozesses in einem gewünschten Arbeits- bzw. Betriebspunkt der Anlage vor. Der Ausgangsgrößenwert kann der Ermittlung der Eingangsgrößenwerte und/oder Parameterwerte und/oder weiterer Ausgangsgrößenwerte dann zugrunde gelegt werden. Mit anderen Worten können bekannte Werte für Ausgangsgrößen bzw. Kenngrößen als Berechnungsgrundlage für zumindest einen Teil der Eingangsgrößen und/oder Parameter und/oder weiteren Ausgangsgrößen, die den Ablauf der Teilprozesse beeinflussen bzw. von denen der Ablauf der Teilprozesse abhängt, dienen. Dadurch können die Modellkomponenten automatisch auf Grundlage des wenigstens einen vorgegebenen Ausgangsgrößenwerts parametriert werden. Es ist für den Benutzer somit nicht notwendig, die aufwändige und gegebenenfalls nur mit speziellem Fachwissen sinnvoll durchführbare Parametrierung der Modellkomponenten manuell durchzuführen. Das Anlagenmodell kann daher auch durch eine domänenfremde Person parametriert und zum Beispiel zur Simulation des Anlagenprozesses genutzt werden.

Einem Automatisierungsingenieur, der sich mit der Leittechnik eines Dampfkraftwerks befasst, sind üblicherweise Ausgangsgrößen, wie zum Beispiel die elektrische Nennleistung des Dampfkraftwerks bekannt, nicht jedoch die genauen Dampfmassenströme und deren Drücke und/oder Temperaturen in einzelnen Turbinenstufen. Das erfindungsgemäße Verfahren erlaubt es nun, die elektrische Nenn- bzw. Ausgangsleistung und gegebenenfalls wenige weitere Prozesswerte oder Werte von Kenn- bzw. Ausgangsgrößen und/oder Eingangsgrößen in einem Arbeitspunkt des Dampfkraftwerks, zum Beispiel unter Volllast, vorzugeben, um ein komplexes Modell des Dampfkraftwerks in der Weise zu parametrieren, dass es mindestens in dem Arbeitspunkt die vorgegebene Nennleistung erzeugt sowie die weiteren vorgegebenen Prozesswerte oder weitere Werte von Kennbzw. Ausgangsgrößen in diesem Arbeitspunkt erreicht. Nicht bekannte Parameter, welche die erzielbare Nennleistung beeinflussen, können automatisch angepasst und müssen vom Automatisierungsingenieur nicht manuell eingestellt werden. Das derart parametrierte Dampfkraftwerkmodell kann vom Automatisierungsingenieur dann dem Test eines Leitsystems, zum Beispiel im Rahmen einer Simulation, zugrunde gelegt werden.

Durch das Ermitteln der Eingangsgrößenwerte und/oder Parameterwerte und/oder weiteren Ausgangsgrößenwerte auf Grundlage wenigstens eines vorgegebenen Ausgangsgrößenwerts in einem Arbeitspunkt und Modellkomponenten, die jeweils physikalische Teilprozesse eines Anlagenprozesses abbilden, kann insbesondere eine durchgängige Nutzung eines einzigen Simulationsmodells (des Anlagenmodells) über den gesamten Lebenszyklus einer Anlage auch durch unterschiedliche Anwender erreicht werden.

Erfindungsgemäß korrespondieren die Modellkomponenten mit physikalischen Modellen. Somit können die Modellkomponenten den Teilprozess jeweils einer Anlagenkomponente abbilden, und zwar vorzugsweise mithilfe mathematischer Gleichungen, die auf physikalischen Zusammenhängen basieren bzw. solche Zusammenhänge beschreiben. Durch die physikalische Modellierung lassen sich hochgenaue und besonders realitätsnahe Modelle bereitstellen. Insbesondere können auch Fehlerszenarien realistisch nachgebildet werden, die zum Beispiel für genaue Trainingssimulationen notwendig sind. Vorzugsweise ist jedes der physikalischen Modelle parametrisiert, wobei die entsprechenden Parameter die Prozess- bzw. Betriebsbedingungen der jeweiligen Anlagenkomponente definieren. Die Eingangsgrößen und/oder Parameter korrespondieren dabei vorzugsweise mit Variablen in den mathematischen Gleichungen. Dies ermöglicht es, physikalische Phänomene im Rahmen der Modellgenauigkeit korrekt nachzubilden und Zusammenhänge physikalisch richtig abzubilden. Insbesondere lässt sich das Verhalten der einzelnen Anlagenkomponenten so besonders präzise und zuverlässig auch in sehr unterschiedlichen Arbeitspunkten der Anlage beschreiben.

Erfindungsgemäß wird zumindest ein Teil der Eingangsgrößenwerte und/oder Parameterwerte und/oder weiteren Ausgangsgrößenwerte beim Ermitteln rückgerechnet, vorzugsweise auf zumindest einen vorgegebenen Arbeitspunkt. Unter einer Rückrechnung ist hierbei vorzugsweise ein, insbesondere mathematisches, Berechnen eines Teils der Eingangsgrößenwerte und/oder Parameterwerte und/oder weiteren Ausgangsgrößenwerte auf Grundlage des wenigstens einen vorgegebenen Ausgangsgrößenwerts zu verstehen. Mit anderen Worten werden dem Ermitteln wenigstens eines Teils der Eingangsgrö-βenwerte und/oder Parameterwerte und/oder weiteren Ausgangsgrößenwerte in bevorzugter Weise mathematische Operationen, insbesondere Rechenoperationen, zugrunde gelegt. Es ist zum Beispiel möglich, die die Anlagenkomponenten beschreibenden Gleichungen zu invertieren, sodass die wenigstens eine Ausgangsgröße, für die ein Wert vorgegeben ist, als Variable dienen kann. Damit kann das Anlagenmodell, insbesondere die mit physikalischen Modellen korrespondierenden Modellkomponenten, auch von domänenfremden Anwendern gehandhabt werden.

Erfindungsgemäß weisen die Modellkomponenten, insbesondere mathematische, Modellgleichungen auf, die zur Rückrechnung der Eingangsgrößenwerte und/oder Parameterwerte und/oder weiteren Ausgangsgrößenwerte gelöst werden. Zu diesem Zweck können die Modellgleichungen gegebenenfalls umgeformt werden. Bei den Modellgleichungen kann es sich zum Beispiel um Differenzgleichungen oder Differenzialgleichungen handeln. Solche Modellgleichungen, gegebenenfalls auch Gleichungssysteme aus mehreren Modellgleichungen, können einzelne Modellkomponenten bzw. die entsprechenden Teilprozesse besonders präzise und physikalisch korrekt abbilden. Insbesondere kann mithilfe des aus solchen Modellkomponenten gebildeten Anlagenmodells der Anlagenprozess auch in selten auftretenden Arbeitspunkten der Anlage, z. B. bei Fehlerfällen, zuverlässig und präzise simuliert werden.

Dadurch, dass dem Anlagenmodell bzw. seinen Modellkomponenten mathematische Modellgleichungen zugrunde gelegt werden und diese z. B. in umgestellter Form zu einer Rückrechnung etwa von unbekannten Parametern verwendet werden, lassen sich die Vorteile eines phänomenologischen (Modellierungs-)Ansatzes, bei dem nur Eingangsgrößen und Ausgangsgrößen betrachtet werden und somit eine komplexe Parametrierung nicht notwendig ist, mit den Vorteilen eines physikalischen Ansatzes, der eine genaue Nachbildung eines realen Anlagenmodells erlaubt, kombinieren. Der wenigstens eine Ausgangsgrößenwert kann zum Beispiel von einem Benutzer frei für einen beliebigen Arbeitspunkt gewählt bzw. vorgegeben werden. In diesem Sinne kann das Anlagenmodell als in ihrer Genauigkeit skalierbar aufgefasst werden. Die wenigstens eine vorgegebene Ausgangsgröße, für die ein Wert vorgegeben ist, wird dann vorzugsweise als Variable in die umgeformte(n) Modellgleichung(en) eingesetzt und zumindest ein Teil der Eingangsgrößen Werte und/oder Parameterwerte und/oder weiteren Ausgangsgrößenwerte abgeleitet. Sind nun mehr und mehr Ausgangsgrößen und/oder Eingangsgrößen und/oder Parameter in weiteren Arbeitspunkten bekannt, kann die Genauigkeit des Anlagenmodells steigen. Damit wird eine skalierbare Genauigkeit ermöglicht.

Erfindungsgemäß werden Differenzgleichungen und/oder Differentialgleichungen in einem stationären Zustand umgeformt, insbesondere zumindest teilweise invertiert. Dabei werden (mathematische) Modellgleichungen, welche eine Dynamik eines Teilprozesses beschreiben, vorzugsweise stationär betrachtet. So ist es zum Beispiel möglich, Teilprozesse im dynamischen Gleichgewicht, zum Beispiel in einem Fließgleichgewicht, in dem Substanzen, Teilchen oder Energie in ein System einströmen und in gleichem Maße wieder ausströmen, zu betrachten und die korrespondierenden Gleichungen unter entsprechenden Gleichgewichtsbedingungen umzuformen, z. B. zu invertieren. Dies kann die Berechnungen vereinfachen und somit die benötigte Rechenleistung bzw. -zeit verringern. Zudem kann so gegebenenfalls auch eine eindeutige Lösung der Modellgleichungen erzielt werden.

Eine Differenzgleichung und/oder Differenzialgleichungen kann dabei beispielsweise in den stationären Zustand überführt werden, etwa indem die zeitliche Änderung einer Variable gleich Null gesetzt wird. Dies erlaubt ein einfaches zumindest teilweises Auflösen der Modellgleichungen nach den Eingangsgrößen und/oder Parametern und/oder weiteren Ausgangsgrößen, für die Werte zu ermitteln sind.

In einer weiteren bevorzugten Ausführungsform wird zur Ermittlung zumindest eines ersten Teils der Eingangsgrößenwerte und/oder Parameterwerte und/oder weiteren Ausgangsgrößenwerte zumindest ein anderer Teil der Parameterwerte vorgegeben. Der andere Teil der Parameterwerte kann dabei durch einen Benutzer, insbesondere manuell, etwa durch Erfassen einer Benutzereingabe, oder automatisch, etwa durch Auslesen aus einer Datenbank, vorgegeben werden. Dies ermöglicht ein Sicherstellen der Lösbarkeit der Modellgleichungen. Insbesondere kann sichergestellt werden, dass für den verbleibenden ersten Teil der Eingangsgrößen und/oder Parameter und/oder weiteren Ausgangsgrößen eindeutige Werte ermittelbar sind, zum Beispiel durch Rückrechnung auf Grundlage umgeformter Modellgleichungen unter Berücksichtigung des anderen Teils der Eingangsgrößen und/oder Parameter und/oder Ausgangsgrößen, für die Werte vorgegeben werden.

In einer weiteren bevorzugten Ausführungsform wird zumindest ein zweiter Teil der Eingangsgrößenwerte und/oder Parameterwerte und/oder weiteren Ausgangsgrößenwerte automatisch auf Grundlage eines vorgegebenen Arbeitspunkts der Anlage vorgegeben und vorzugsweise der Ermittlung des ersten Teils der Eingangsgrößenwerte und/oder der Parameterwerte und/oder der weiteren Ausgangsgrößenwerte zugrunde gelegt. Mit anderen Worten werden vorzugsweise Annahmen für zumindest einen zweiten Teil der in den Anlagenkomponenten verwendeten bzw. in die entsprechenden Modellgleichungen eingehenden Eingangsgrößen und/oder Parameter und/oder Ausgangsgrößen getroffen. Diese Annahmen basieren dabei in bevorzugter Weise auf dem vorgegebenen Arbeitspunkt der Anlage. Der vorgegebene Arbeitspunkt kann dabei insbesondere mit dem vorgegebenen Ausgangsgrößenwert korrespondieren. Dies kann die Anwendung des Anlagenmodells, insbesondere für einen domänenfremden Benutzer, erheblich vereinfachen und/oder beschleunigen.

Der zweite Teil der Eingangsgrößenwerte und/oder Parameterwerte und/oder weiteren Ausgangsgrößenwerte bildet dabei vorzugsweise Prozessbedingungen ab, z. B. Drücke, Temperaturen, Massenströme und/oder dergleichen, die den vorgegebenen Arbeitspunkt charakterisieren, insbesondere typisch und/oder notwendig für den Betrieb der Anlage in diesem Arbeitspunkt sind. Entspricht der vorgegebene Ausgangsgrößenwert beispielsweise einer maximalen Ausgangsleistung der Anlage, kann ein maximaler Öffnungsgrad eines Ventils, eine maximale Drehzahl einer Welle, eine maximale Förderleistung einer Pumpe und/oder dergleichen vorgegeben werden. Alternativ oder zusätzlich ist es denkbar, Parameterwerte mit möglichen Arbeitspunkten der Anlage in einer Datenbank zu verknüpfen, sodass bei Vorgabe eines Arbeitspunkts die entsprechend vorzugebenen Parameterwerte zuverlässig und schnell bereitstehen.

In einer weiteren bevorzugten Ausführungsform wird zumindest ein dritter Teil der Eingangsgrößenwerte und/oder Parameterwerte und/oder weiteren Ausgangsgrößenwerte in einem Parametriermodus über eine Benutzerschnittstelle erfasst und vorzugsweise der Ermittlung des ersten Teils der Eingangsgrößenwerte und/oder der Parameterwerte und/oder der weiteren Ausgangsgrößenwerte zugrunde gelegt. Mit anderen Worten werden der Ermittlung des ersten Teils der Eingangsgrößenwerte und/oder der Parameterwerte und/oder der weiteren Ausgangsgrößenwerte vorzugsweise vom Benutzer vorgegebene Parameterwerte zugrunde gelegt. Dadurch lässt sich die Parametrierung des Anlagenmodells weiter verbessern. Wenn der Benutzer beispielsweise nur über entsprechendes Fachwissen in einem Bereich verfügt, der einen Teil des Anlagenprozesses bzw. nur einen Teil der Anlagenkomponenten betrifft, kann er auf diese Weise zumindest ausgewählte Parameter manuell festlegen, d. h. deren Werte bestimmen.

In einer weiteren bevorzugten Ausführungsform wird der Anlagenprozess auf Grundlage der ermittelten Eingangsgrößenwerte und/oder Parameter und/oder weiterer Ausgangsgrößenwerte simuliert. Mit anderen Worten kann das derart parametrierte Anlagenmodell einer Simulation der Anlage zugrunde gelegt werden. Dies erlaubt es auch domänenfremden Personen, Simulationen der Anlage durchzuführen, zum Beispiel in unterschiedlichen Abschnitten des Lebenszyklus der Anlage.

In einer weiteren bevorzugten Ausführungsform werden in einem Simulationsmodus über eine Benutzerschnittstelle erfasste Benutzereingaben der Simulation des Anlagenprozesses zugrunde gelegt. Dabei kann es sich um dieselbe Benutzerschnittstelle handeln, über die der Benutzer gegebenenfalls den dritten Teil der Parameterwerte vorgeben kann. Der Benutzer kann so beispielsweise einzelne Eingangsgrößen und/oder Parameter und/oder weitere Ausgangsgrößenwerte variieren und deren Auswirkung, insbesondere auf die vorgegebene Ausgangsgröße, untersuchen.

Ein System zur Parametrierung eines Anlagenmodells gemäß einem zweiten Aspekt der Erfindung weist eine Benutzerschnittstelle, ein Modellierungsmodul und ein Parametrierungsmodul auf. Die Benutzerschnittstelle ist dabei dazu eingerichtet, wenigstens einen Ausgangsgrößenwert in einem Arbeitspunkt einer Anlage zu erfassen, während das Modellierungsmodul dazu eingerichtet ist, ein Modell der Anlage aus mehreren Modellkomponenten, die physikalische Teilprozesse des Anlagenprozesses abbilden, bereitzustellen. Das Parametrierungsmodul ist schließlich dazu eingerichtet, Eingangsgrößenwerte und/oder Parameterwerte und/oder weitere Ausgangsgrößenwerte der Teilprozesse auf Grundlage der Modellkomponenten und des wenigstens einen vorgegebenen Ausgangsgrößenwerts zu ermitteln.

Das System kann hard- und/oder softwaretechnisch ausgebildet sein. Die Vorrichtung kann insbesondere eine, vorzugsweise mit einem Speicher- und/oder Bussystem daten- bzw. signalverbundene, insbesondere digitale, Verarbeitungseinheit aufweisen, z. B. eine Mikroprozessoreinheit (CPU) oder ein Modul einer solchen und/oder ein oder mehrere Programme oder Programmmodule. Die CPU kann dazu ausgebildet sein, Befehle, die als ein in einem Speichersystem abgelegtes Programm implementiert sind, abzuarbeiten, Eingangssignale von einem Datenbus zu erfassen und/oder Ausgangssignale an einen Datenbus abzugeben. Ein Speichersystem kann ein oder mehrere, insbesondere verschiedene, Speichermedien, insbesondere optische, magnetische, Festkörper- und/oder andere nicht-flüchtige Medien, aufweisen. Ein Programm kann derart beschaffen sein, dass es die hier beschriebenen Verfahren verkörpert bzw. auszuführen imstande ist, sodass die CPU die Schritte solcher Verfahren ausführen kann und damit insbesondere ein Anlagenmodell parametrieren kann.

Die Benutzerschnittstelle weist dabei vorzugsweise eine grafische Benutzeroberfläche auf, z. B. eine Eingabemaske, über welche ein Benutzer den wenigstens einen Ausgangsgrößenwert, gegebenenfalls auch den dritten Teil der Eingangsgrößenwerte und/oder Parameterwerte und/oder weiteren Ausgangsgrößenwerte, vorgeben bzw. eintragen kann.

Das Modellierungsmodul ist dabei vorzugsweise dazu eingerichtet, das Anlagenmodell zu erzeugen, zum Beispiel indem es mehrere vorgegebene, etwa in einem Speicher oder einer Datenbank gespeicherte, Modellkomponenten kombiniert. Alternativ kann das Modellierungsmodul aber auch eine Kommunikations- bzw. Datenschnittstelle aufweisen, über welche das Modellierungsmodul das Anlagenmodell empfangen kann.

In einer bevorzugten Ausführungsform weist das System ein Simulationsmodul auf, welches dazu eingerichtet ist, den Anlagenprozess auf Grundlage der ermittelten Eingangsgrößenwerte und/oder Parameterwerte und/oder weiteren Ausgangsgrößenwerte zu simulieren. Dies erlaubt es auch domänenfremden Personen, Simulationen der Anlage durchzuführen, zum Beispiel in unterschiedlichen Abschnitten des Lebenszyklus der Anlage.

Die bisher gegebene Beschreibung bevorzugter Ausführungsformen der Erfindung enthält zahlreiche Merkmale, die in den einzelnen abhängigen Ansprüchen teilweise zu mehreren zusammengefasst wiedergegeben sind. Diese Merkmale können jedoch auch einzeln betrachtet und zu sinnvollen weiteren Kombinationen zusammengefasst werden. Insbesondere sind diese Merkmale jeweils einzeln und in beliebiger geeigneter Kombination mit dem Verfahren gemäß dem ersten Aspekt der Erfindung und dem System gemäß dem zweiten Aspekt der Erfindung kombinierbar.

Die voranstehend beschriebenen Eigenschaften, Merkmale und Vorteile der Erfindung sowie die Art und Weise, wie diese erreicht werden, werden im Zusammenhang mit den Figuren in der folgenden Beschreibung von Ausführungsbeispielen der Erfindung näher erläutert. In den Figuren werden durchgängig dieselben Bezugszeichen für dieselben oder einander entsprechende Elemente der Erfindung verwendet. Die Ausführungsbeispiele dienen der Erläuterung der Erfindung und beschränken die Erfindung nicht auf die darin angegebenen Kombinationen von Merkmalen, auch nicht in Bezug auf funktionale Merkmale. Außerdem können dazu geeignete Merkmale der Ausführungsbeispiele auch explizit isoliert betrachtet und mit einem beliebigen der Ansprüche kombiniert werden.

Es zeigen, zumindest teilweise schematisch:

FIG 1 ein Beispiel eines Anlagenmodells aus mehreren Modellkomponenten;

FIG 2 ein Beispiel eines Systems zum Parametrieren eines Anlagenmodells; und

FIG 3 ein Beispiel eines Verfahrens zum Parametrieren eines Anlagenmodells.

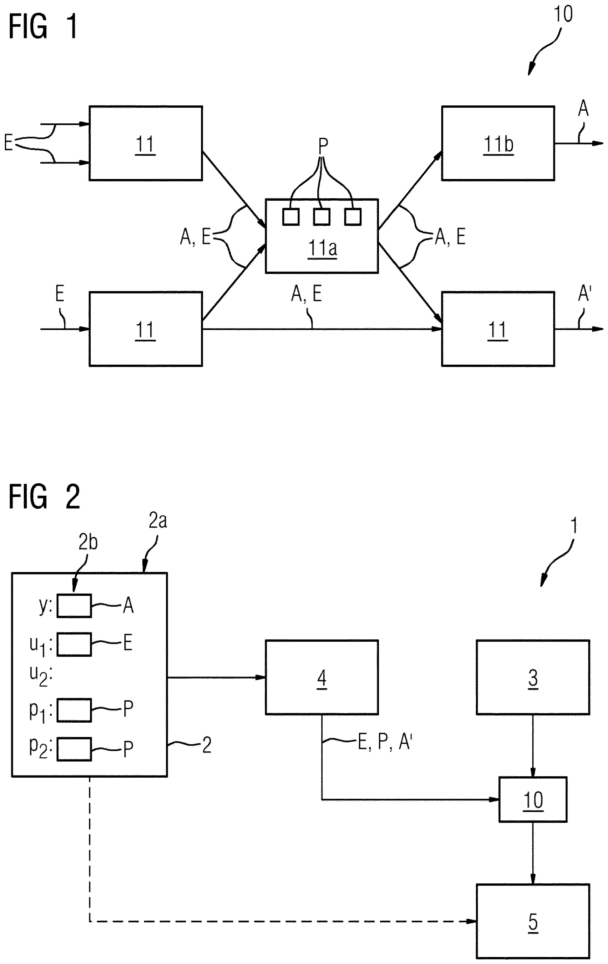

FIG 1 zeigt ein Beispiel eines Anlagenmodells 10 aus mehreren Modellkomponenten 11, die jeweils einen physikalischen Teilprozess eines Anlagenprozesses, d. h. eines von der modellierten Anlage durchgeführten Prozesses, abbilden. Die Teilprozesse laufen dabei ab auf Grundlage von Eingangsgrößen, die Werte E annehmen können, und Parametern, die Werte P annehmen können. Die Teilprozesse liefern Ausgangsgrößen, die Werte A annehmen können. Diese Ausgangsgrößenwerte A können als Ergebnis des jeweils ablaufenden Teilprozesses aufgefasst werden. Aus Gründen der Übersichtlichkeit sind Parameterwerte P nur für eine Anlagenkomponente 11a dargestellt.

Eine Ausgangsgröße einer Modellkomponente 11 kann dabei als Eingangsgröße einer anderen, im Verlauf des Anlagenprozesses nachgeordneten Modellkomponente 11 dienen. In FIG 1 ist dies beispielhaft für die Modellkomponenten 11a und 11b gezeigt. Hierbei entspricht der Ausgangsgrößenwert A der Modellkomponente 11a im Rahmen des Anlagenmodells 10 dem Eingangsgrößenwert E der Modellkomponente 11b. Die durch die Modellkomponenten 11 abgebildeten Teilprozesse laufen somit nicht unabhängig voneinander ab. Vielmehr kann der Verlauf bzw. können die Prozessbedingungen eines vorangehenden Teilprozesses auch den Ablauf eines nachfolgenden Teilprozesses beeinflussen.

Beispielsweise kann das mithilfe einer etwa durch die Anlagenkomponente 11a repräsentierten Turbinenstufe erzeugte Moment entscheidend dafür sein, wie hoch die von einem durch die Modellkomponente 11b repräsentierten Generator erzeugte Leistung ist.

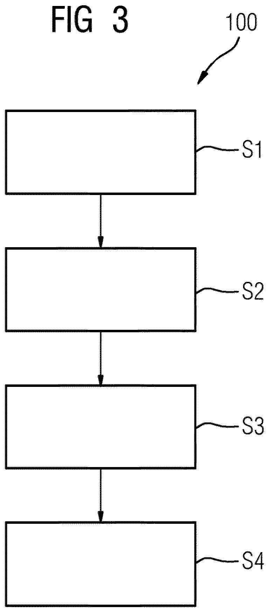

Diese Abhängigkeit der Ausgangsgrößen von den Eingangsgrößen und Parametern gilt aber auch umgekehrt und kann in einem Verfahren zur Parametrierung des Anlagenmodells 10, wie es z. B. im Zusammenhang mit FIG 3 beschrieben ist, ausgenutzt werden. Bei einer Vorgabe mindestens eines Ausgangsgrößenwertes A können somit zumindest die Eingangsgrößenwerte E, gegebenenfalls auch zumindest ein Teil der Parameterwerte P und/oder weitere Ausgangsgrößenwerte A', einer Anlagenkomponente 11 ermittelt werden.

Die Parameterwerte P bilden dabei vorzugsweise diejenigen relevanten Prozessbedingungen ab, die unabhängig von anderen Modellkomponenten 11 bzw. den dort ablaufenden Teilprozessen herrschen oder eingestellt werden können. Die Parameterwerte P können alternativ oder zusätzlich auch die jeweils modellierte Anlagenkomponente bzw. deren Eigenschaften und/oder Betriebszustand charakterisieren. Beispiele dafür sind eine von der betreffenden Modellkomponente 11 in den Anlagenprozess eingebrachte einstellbare Leistung, zum Beispiel eine Motorleistung oder die Leistung eine Kühlung, oder eine Aktuatorstellung, zum Beispiel der Öffnungsgrad eines Ventils.

Die Modellkomponenten 11 können diese Parameterwerte P und entsprechende Eingangsgrößenwerte E sowie weiteren Ausgangsgrößenwerte A' zum Beispiel durch mathematische Gleichungen oder Gleichungssysteme berücksichtigen. Mit anderen Worten können die Anlagenkomponenten durch solche Gleichungen oder Gleichungssysteme modelliert sein, wobei die Eingangsgrößenwerte E, weitere Ausgangsgrößenwerte A' und Parameterwerte P als Variable eingehen.

Eine Anlagenkomponente kann zum Beispiel durch eine Modellkomponente 11 in Form einer Gleichung

$$\vec{y} = g(\vec{x}, \vec{p}_3) + m(\vec{u}, \vec{p}_4)$$

modelliert sein, wobei $g$ und $m$ Funktionen, $y$ eine Ausgangsgröße, $u$ eine Eingangsgröße und $p_3$, $p_4$ Parameter sind. $y$ kann entsprechend Werte A und $u$ Werte E annehmen. $p_3$, $p_4$ können Werte P annehmen.

Die Modellkomponente 11 kann zudem eine weitere Gleichung aufweisen, welche die Dynamik der modellierten Anlagenkomponente abbildet, etwa:

$$\dot{\vec{x}} = f(\vec{x}, \vec{p}_1) + k(\vec{u}, \vec{p}_2),$$

wobei $x$ einen Zustand der Anlagenkomponente und $\dot{x}$ die zeitliche Änderung des Zustands beschreibt. Des Weitern sind $p_1$, $p_2$ Parameter, und $f$ und $k$ sind Funktionen.

FIG 2 zeigt ein Beispiel eines Systems 1 zum Parametrieren eines Anlagenmodells 10, mit einer Benutzerschnittstelle 2, einem Modellierungsmodul 3, einem Parametrierungsmodul 4 und einem Simulationsmodul 5.

Das Modellierungsmodul 3 ist dabei dazu eingerichtet, das Anlagenmodell 10 in Form mehrerer Modellkomponenten, die jeweils physikalische Teilprozesse eines Anlagenprozesses abbilden, bereitzustellen. Das Modellierungsmodul 3 kann zu diesem Zweck als Softwaremodul mit einer grafischen Benutzeroberfläche ausgebildet sein, die es einem Benutzer erlaubt, das Anlagenmodell 10 zu erzeugen, beispielsweise aus den Modellkomponenten zusammenzustellen. Die Modellkomponenten entsprechen dabei vorzugsweise vordefinierten bzw. vorkonfigurierten Modellkomponenten, die in modularer Weise zusammensetzbar sind. Alternativ oder zusätzlich können die Modellkomponenten durch den Benutzer konfiguriert, insbesondere erzeugt, werden, wodurch dem Benutzer eine besonders große Freiheit bei der Gestaltung des Anlagenmodells 10 ermöglicht wird.

Alternativ ist es aber auch denkbar, dass das Modellierungsmodul 3 eine Kommunikations- bzw. Datenschnittstelle aufweist, welche dazu eingerichtet ist, ein zum Beispiel von einem externen Softwaremodul erzeugtes Anlagenmodell 10 zu empfangen. Dies ermöglicht ein schlankes System 1.

Die Modellkomponenten weisen dabei vorzugsweise Gleichungen oder Gleichungssysteme auf, welche die physikalischen Eigenschaften der modellierten Anlagenkomponenten und die physikalischen Zusammenhänge zwischen den Anlagenkomponenten bzw. den korrespondierenden Teilprozessen widerspiegeln.

Die Benutzerschnittstelle 2 ist dazu eingerichtet, wenigstens einen zum Beispiel von dem Benutzer vorgegebenen Ausgangsgrö-βenwert A für eine Ausgangsgröße **y** zu erfassen. Zu diesem Zweck kann die Benutzerschnittstelle 2 ebenfalls eine grafische Benutzeroberfläche 2a aufweisen, in welcher der Benutzer den Ausgangsgrößenwert A beispielsweise in ein entsprechendes Eingabefeld 2b eintragen kann.

Die Benutzerschnittstelle 2 ist zudem dazu eingerichtet, für jede der Modellkomponenten Eingangsgrößenwerte E für Eingangsgrößen $u_1$, die nicht durch eine andere Modellkomponente bestimmt werden, sowie Parameterwerte P für Parameter $p_1$, $p_2$ zu erfassen. Dagegen werden solche Eingangsgrößen $u_2$, die durch andere Modellkomponenten 11 bestimmt werden, von der Benutzerschnittstelle 2 vorzugsweise nicht erfasst. In FIG 2 ist dies dadurch angedeutet, dass der Eingangsgröße $u_2$ kein Eingabefeld 2b zugeordnet ist.

Das Parametrierungsmodul 4 ist dazu eingerichtet, Eingangsgrößenwerte E und/oder Parameterwerte P und/oder weitere Ausgangsgrößenwerte A auf Grundlage des mithilfe der Benutzerschnittstelle 2 vorgegebenen Ausgangsgrößenwerts A zu ermitteln, und zwar insbesondere für solche Eingangsgrößen $u_2$ und Parameter $p_1$, $p_2$, für die keine Eingangsgrößenwerte E bzw. Parameterwerte P erfasst wurden.

Zu diesem Zweck kann das Parametrierungsmodul 4 dazu eingerichtet sein, die Gleichungen und/oder Gleichungssysteme aus den Modellkomponenten gegebenenfalls umzuformen und zu lösen. Ist die Lösung nicht eindeutig möglich, kann das Parametrierungsmodul 4 Annahmen für einzelne, nicht durch den Benutzer vorgegebene Parameterwerte P und/oder Eingangsgrößenwerte E und/oder weitere Ausgangsgrößenwerte A' treffen und diese Parameterwerte P und/oder Eingangsgrößenwerte E und/oder weiteren Ausgangsgrößenwerte A' selber vorgeben. Dabei kann das Parametrierungsmodul 4 beispielsweise entsprechende Parameterwerte P aus einem Speicher bzw. einer Datenbank auslesen, die dort mit einem Arbeitspunkt der Anlage, der vorzugsweise mit dem vorgegebenen Ausgangsgrößenwert A korrespondiert, verknüpft sind.

Das Parametrierungsmodul 4 kann dazu eingerichtet sein, die Eingangsgrößenwerte E und/oder Parameterwerte P und/oder weitere Ausgangsgrößenwerte A' in stationären Zuständen $\dot{x} = 0$ von dynamischen Teilprozessen der Modellkomponenten zu ermitteln. Eine Differenzialgleichung, welche die Dynamik eines Teilprozesses zum Beispiel durch die Gleichung

$$\dot{\vec{x}} = f(\vec{x}, \vec{p}_1) + k(\vec{u}, \vec{p}_2)$$

beschreibt, kann im stationären Zustand nach

$$\vec{x} = -f^{-1}(\vec{p}_1) \cdot k(\vec{u}, \vec{p}_2)$$

umgeformt werden. Dabei beschreibt **x** den Zustand der Anlagenkomponente und $\dot{x}$ die zeitliche Änderung des Zustands. **f** und **k** sind Funktionen. Eine Gleichung, welche die Ausgangsgröße y gemäß

$$\vec{y} = g(\vec{x}, \vec{p}_3) + m(\vec{u}, \vec{p}_4)$$

beschreibt, kann dann beispielsweise zum Ermitteln der Eingangsgröße u entsprechend aufgelöst werden:

$$\vec{u} = H(\vec{y}, \vec{x}, \vec{p}_1, \vec{p}_2, \vec{p}_3, \vec{p}_4).$$

**H** ist dabei eine weitere Funktion, und $p_3$ und $p_4$ weitere Parameter.

Das Simulationsmodul 5 ist schließlich dazu eingerichtet, die Anlage bzw. den Betrieb der Anlage, insbesondere den Anlagenprozess, auf Grundlage des derart parametrierten Anlagenmodells 10 zu simulieren. Dabei ist eine in FIG 2 durch den gestrichelten Pfeil angedeutet Kopplung der Benutzerschnittstelle 2 mit dem Simulationsmodul 5 denkbar. Dadurch kann der Benutzer zur Simulation des Anlagenprozesses einen oder mehrere Eingangsgrößenwerte E und/oder Parameterwerte P und/oder weitere Ausgangsgrößenwerte A' mithilfe der Benutzerschnittstelle 2 für einzelne Modellkomponenten ändern oder durch Einbindung in weitere Simulationstools, zum Beispiel eine Leitsystemsimulation, gegebenenfalls automatisch und/oder dynamisch ändern lassen.

**FIG 3** zeigt ein Beispiel eines Verfahrens 100 zur Parametrisierung eines Anlagenmodells aus mehreren Modellkomponenten, welche Teilprozesse eines Anlagenprozesses abbilden.

In einem Verfahrensschritt S1 wird das Anlagenmodell bereitgestellt, zum Beispiel erzeugt oder empfangen. Zu diesem Zweck kann ein Modellierungsmodul vorgesehen sein.

Die Modellkomponenten des Anlagenmodells weisen dabei Eingangsgrößen und Parameter sowie Ausgangsgrößen auf, welche den Ablauf bzw. das Ergebnis der entsprechenden Teilprozesse beeinflussen.

In einem weiteren Verfahrensschritt S2 wird wenigstens ein Ausgangsgrößenwert des Anlagenprozesses in einem Arbeitspunkt der Anlage vorgegeben, etwa von einem Benutzer mithilfe einer Benutzerschnittstelle. Dabei kann auch ein dritter Teil der Eingangsgrößenwerte und/oder Parameterwerte und/oder weiteren Ausgangsgrößen vorgegeben werden, sofern diese Eingangsgrößenwerte und/oder Parameterwerte und/oder weiteren Ausgangsgrößenwerte nicht im Rahmen des Anlagenmodells durch den Anlagenprozess bzw. einzelne Teilprozesse selbst bestimmt werden, d. h. als Ausgangsgrößenwert einer Modellkomponenten ausgegeben oder als Eingangsgrößenwerte einer anderen Modellkomponente vorgegeben werden, und dem Benutzer bekannt sind bzw. der Benutzer über das entsprechende Fachwissen verfügt.

In einem weiteren Verfahrensschritt S3 werden Eingangsgrößenwerte und/oder Parameterwerte und/oder weitere Ausgangsgrö-βenwerte der Teilprozesse, insbesondere ein erster Teil der Eingangsgrößenwerte und/oder Parameterwerte und/oder weiteren Ausgangsgrößenwerte, auf Grundlage der Modellkomponenten und des wenigstens einen vorgegebenen Ausgangsgrößenwerts ermittelt, insbesondere auf Grundlage einer Rückrechnung. Die Rückrechnung stützt sich dabei vorzugsweise auf Modellgleichungen der Modellkomponenten, die mit physikalischen Modellen korrespondieren. Diese Modellgleichungen können, wo notwendig, umgeformt und dann gelöst werden.

Kann durch die Rückrechnung ein zweiter Teil der zu ermittelnden Eingangsgrößen und/oder Parameterwerte und/oder weiteren Ausgangsgrößenwerte nicht eindeutig bestimmt werden, d. h. ergibt sich keine eindeutige Lösung für die Modellgleichungen, können diese Eingangsgrößenwerte und/oder Parameterwerte und/oder weiteren Ausgangsgrößenwerte auch automatisch vorgegeben werden. Alternativ oder zusätzlich können die Parameterwerte auch auf Grundlage des in Verfahrensschritt S2 vorgegebenen dritten Teils der Eingangsgrößenwerte und/oder Parameterwerte und/oder weiteren Ausgangsgrößenwerte ermittelt werden. Dies ermöglicht eine zuverlässige automatische Parametrisierung des Anlagenmodells.

In einem weiteren Verfahrensschritt S4 wird die Anlage bzw. deren Betrieb, insbesondere der Anlagenprozess, auf Grundlage des parametrisierten Anlagenmodells simuliert.

Bezugszeichenliste

1    System
2    Benutzerschnittstelle
2a   graphische Benutzeroberfläche
2b   Eingabefeld
3    Modellierungsmodul
4    Parametrierungsmodul
5    Simulationsmodul

10    Anlagenmodell
11    Modellkomponente
11a, 11b    vorangehende und nachfolgende Modellkomponente

100    Verfahren

S1-S4    Verfahrensschritte

y    Ausgangsgröße
A    Ausgangsgrößenwert
A'   weiterer Ausgangsgrößenwert
u    Eingangsgröße
E    Eingangsgrößenwert
p    Parameter
P    Parameterwert

**Patentansprüche**

1.  Verfahren (100) zur Parametrierung eines Anlagenmodells (10), mit den Schritten:

    - Bereitstellen (S1) eines Anlagenmodells (10) aus mehreren Modellkomponenten (11), die physikalische Teilprozesse eines Anlagenprozesses abbilden und die mit physikalischen Modellen korrespondieren;
    - Vorgeben (S2) wenigstens eines Ausgangsgrößenwerts (A) des Anlagenprozesses in einem Arbeitspunkt der Anlage; und
    Ermitteln (S3) von Eingangsgrößenwerten (E) und/oder Parameterwerten (P) und/oder weiterer Ausgangsgrößenwerte (A') der Teilprozesse auf Grundlage der Modellkomponenten (11) und des wenigstens einen vorgegebenen Ausgangsgrößenwerts (A), wobei zumindest ein Teil der Eingangsgrößenwerte (E) und/oder Parameterwerte (P) und/oder weiterer Ausgangsgrößenwerte (A') beim Ermitteln (S3) rückgerechnet wird, und wobei die Modellkomponenten (11) Modellgleichungen aufweisen, die zur Rückrechnung der Eingangsgrößenwerte (E) und/oder Parameterwerte (P) und/oder weiterer Ausgangsgrößenwerte (A') gelöst werden, wobei Differentialgleichungen in einem stationären Zustand umgeformt werden.

2.  Verfahren (100) nach Anspruch 1,
    **dadurch gekennzeichnet,**
    **dass** zur Ermittlung (S3) zumindest eines ersten Teils der Eingangsgrößenwerte (E) und/oder der Parameterwerte (P) und/oder weiterer Ausgangsgrößenwerte (A') zumindest ein anderer Teil der Eingangsgrößenwerte (E) und/oder Parameterwerte (P) und/oder weiterer Ausgangsgrößenwerte (A') vorgegeben wird.

**3.** Verfahren (100) nach einem der vorangehenden Ansprüche,
**dadurch gekennzeichnet,**
**dass** ein zweiter Teil der Eingangsgrößenwerte (E) und/oder Parameterwerte (P) und/oder weiteren Ausgangsgrößenwerten (A') automatisch auf Grundlage eines vorgegebenen Arbeitspunkts der Anlage vorgegeben wird.

**4.** Verfahren (100) nach einem der vorangehenden Ansprüche,
**dadurch gekennzeichnet,**
**dass** zumindest ein dritter Teil der Eingangsgrößenwerte (E) und/oder Parameterwerte (P) und/oder weiteren Ausgangsgrößenwerte (A') in einem Parametriermodus über eine Benutzerschnittstelle (2) erfasst wird.

**5.** Verfahren (100) nach einem der vorangehenden Ansprüche,
**gekennzeichnet durch**
Simulieren (S4) des Anlagenprozesses auf Grundlage der ermittelten Eingangsgrößenwerte (E) und/oder Parameter (P) und/oder weiteren Ausgangsgrößenwerte (A').

**6.** Verfahren (100) nach Anspruch 5,
**dadurch gekennzeichnet,**
**dass** in einem Simulationsmodus über eine Benutzerschnittstelle (2) erfasste Benutzereingaben der Simulation (S4) des Anlagenprozesses zugrunde gelegt werden.

**7.** System (1) zur Parametrierung eines Anlagenmodells (10), mit

- einer Benutzerschnittstelle (2), die dazu eingerichtet ist, wenigstens einen Ausgangsgrößenwert (A) in einem Arbeitspunkt einer Anlage zu erfassen (S2),
- einem Modellierungsmodul (3), das dazu eingerichtet ist, ein Modell (10) der Anlage aus mehreren Modellkomponenten (11), die physikalische Teilprozesse des Anlagenprozesses abbilden und die mit physikalischen Modellen korrespondieren, zu erstellen (S1), und
- einem Parametrierungsmodul (4), das dazu eingerichtet ist, Eingangsgrößenwerte (E) und/oder Parameterwerte (P) und/oder weitere Ausgangsgrößenwerte (A') der Teilprozesse auf Grundlage der Modellkomponenten (11) und des wenigstens einen vorgegebenen Ausgangsgrößenwerts (A) zu ermitteln (S3), wobei zumindest ein Teil der Eingangsgrößenwerte (E) und/oder Parameterwerte (P) und/oder weiteren Ausgangsgrößenwerte (A') beim Ermitteln (S3) rückgerechnet wird, und wobei die Modellkomponenten (11) Modellgleichungen aufweisen, die zur Rückrechnung der Eingangsgrößenwerte (E) und/oder Parameterwerte (P) und/oder weiteren Ausgangsgrößenwerte (A') gelöst werden, wobei Differentialgleichungen in einem stationären Zustand umgeformt werden.

**8.** System (1) nach Anspruch 7 mit einem Simulationsmodul (5), welches dazu eingerichtet ist, den Anlagenprozess auf Grundlage der ermittelten Eingangsgrößenwerte (E) und/oder Parameterwerte (P) und/oder weiteren Ausgangsgrößenwerte (A') zu simulieren (S4).

**Claims**

**1.** Method (100) for parameterisation of a plant model (10), with the steps:

- providing (S1) a plant model (10) comprising a plurality of model components (11), which map physical sub-processes of a plant process and which correspond to physical models;
- specifying (S2) at least one output variable value (A) of the plant process in an operating point of the plant; and
ascertaining (S3) input variable values (E) and/or parameter values (P) and/or further output variable values (A') of the sub-processes on the basis of the model components (11) and the at least one specified output variable value (A), wherein at least one portion of the input variable values (E) and/or parameter values (P) and/or further output variable values (A') is back-calculated during ascertaining (S3), and wherein the model components (11) have model equations, which are solved in order to recalculate the input variable values (E) and/or parameter values (P) and/or further output variable values (A'), wherein differential equations are transformed in a stationary state.

**2.** Method (100) according to claim 1,
**characterised in that**
to ascertain (S3) at least a first portion of the input variable values (E) and/or the parameter values (P) and/or further output variable values (A'), at least a different portion of the input variable values (E) and/or parameter values (P) and/or further output variable values (A') is specified.

**3.** Method (100) according to one of the preceding claims,
**characterised in that**
a second portion of the input variable values (E) and/or parameter values (P) and/or further output variable values (A') is automatically specified on the basis of a specified operating point of the plant.

**4.** Method (100) according to one of the preceding claims,
**characterised in that**
at least a third portion of the input variable values (E) and/or parameter values (P) and/or further output variable values (A') is acquired in a parameterising mode via a user interface (2).

**5.** Method (100) according to one of the preceding claims,
**characterised by**
simulating (S4) the plant process on the basis of the ascertained input variable values (E) and/or parameters (P) and/or further output variable values (A').

**6.** Method (100) according to claim 5,
**characterised in that**
user inputs acquired in a simulation mode via a user interface (2) form the basis of the simulation (S4) of the plant process.

**7.** System (1) for parameterisation of a plant model (10), with

- a user interface (2), which is configured to acquire at least one output variable value (A) in an operating point of a plant (S2),
- a modelling module (3), which is configured to create a model (10) of the plant from a plurality of model components (11), which map physical sub-processes of the plant process and which correspond to physical models (S1), and
- a parameterisation module (4), which is configured to ascertain input variable values (E) and/or parameter values (P) and/or further output variable values (A') of the sub-processes on the basis of the model components (11) and the at least one specified output variable value (A) (S3), wherein at least one portion of the input variable values (E) and/or parameter values (P) and/or further output variable values (A') is back-calculated during ascertaining (S3), and wherein the model components (11) have model equations, which are solved in order to recalculate the input variable values (E) and/or parameter values (P) and/or further output variable values (A'), wherein differential equations are transformed in a stationary state.

**8.** System (1) according to claim 7 with a simulation module (5), which is configured to simulate (S4) the plant process on the basis of the ascertained input variable values (E) and/or parameter values (P) and/or further output variable values (A').

**Revendications**

**1.** Procédé (100) de paramétrage d'un modèle (10) d'installation, comprenant les stades :

- on se procure (S1) un modèle (10) d'installation composé de plusieurs composants (11) de modèle, qui représentent des processus partiels physiques d'un processus d'installation et qui correspondent à des modèles physiques ;
- on prescrit (S2) au moins une valeur (A) de grandeur de départ du processus de l'installation en un point de travail de l'installation ; et on détermine (S3) des valeurs (E) de grandeur d'entrée et/ou des valeurs (P) de paramètres et/ou d'autres valeurs (A") de grandeur de sortie des processus partiels sur la base des composants (11) du modèle et de la au moins une valeur (A) de grandeur de sortie prescrite, dans lequel, lors de la détermination (S3), on calcul en retour au moins une partie des valeurs (E) de grandeur d'entrée et/ou des valeurs (P) de paramètres et/ou d'autres valeurs (A") de grandeur de sortie,
et dans lequel les composants (11) du modèle ont des équations de modèle, qui sont résolues pour le calcul en retour des valeurs (E) de grandeur d'entrée et/ou des valeurs (P) de paramètres et/ou d'autres valeurs (A") de grandeur de sortie, des équations différentielles étant transformées en un état stationnaire.

**2.** Procédé (100) suivant la revendication 1,
**caractérisé**
**en ce que**, pour la détermination (S3) d'au moins une partie des valeurs (E) de grandeur d'entrée et/ou des valeurs (P) de paramètres et/ou d'autres valeurs (A") de grandeur de sortie, on prescrit au moins une autre partie des valeurs (E) de grandeur d'entrée et/ou des valeurs (P) de paramètres et/ou d'autres valeurs (A") de grandeur de sortie.

**3.** Procédé (100) suivant l'une des valeurs précédentes,
**caractérisé**
**en ce que** l'on prescrit automatiquement sur la base d'un point de travail prescrit de l'installation une deuxième partie des valeurs (E) de grandeur d'entrée et/ou des valeurs (P) de paramètres et/ou d'autres valeurs (A') de valeur de sortie.

**4.** Procédé (100) suivant l'une des revendications précédentes,
**caractérisé**
**en ce que** l'on détecte par une interface (2) d'utilisateur, dans un mode de paramétrage, une troisième partie des valeurs (E) de valeur d'entrée et/ou des valeurs (P) de paramètres et/ou d'autres valeurs (A") de grandeur d'entrée.

5. Procédé (100) suivant l'une des revendications précédentes,
**caractérisé par**
une simulation (S4) du processus de l'installation sur la base des valeurs (E) de grandeur d'entrée et/ou des valeurs (P) de paramètres et/ou d'autres valeurs (A') de valeur sortie déterminées.

6. Procédé (100) suivant la revendication 5,
**caractérisé**
**en ce que**, dans un mode de simulation, des entrées d'utilisateur, détectées par une interface (2) d'utilisateur, sont mises à la base de la simulation (S4) du processus de l'installation.

7. Système (1) de paramétrage d'un modèle (10) d'installation, comprenant

    - une interface (2) d'utilisateur, qui est agencée pour détecter au moins une valeur (A) de grandeur de sortie à un point de travail d'une installation (S2),
    - un module (3) de modélisation, qui est agencé pour établir un modèle (10) de l'installation composé de plusieurs composants (11) de modèles, qui reproduisent des processus partiels physiques du processus de l'installation et qui correspondent à des modèles physiques (S1), et

un module (4) de paramétrage, qui est agencé pour déterminer des valeurs (E) de grandeur d'entrée et/ou des valeurs (P) de paramètres et/ou d'autres valeurs (A") de grandeur de sortie des processus partiels sur la base des composants (11) du modèle et/ou de la au moins une valeur (A) de grandeur de sortie prescrite (S3), dans lequel, lors de la détermination (S3), on calcule en retour au moins une partie des valeurs (E) de grandeur d'entrée et/ou des valeurs (P) de paramètres et/ou d'autres valeurs (A") de grandeur de sortie, et dans lequel les composants (11) du modèle ont des équations de modèle , qui sont résolues pour le calcul en retour des valeurs (E) de grandeur d'entrée et/ou des valeurs (P) de paramètres et/ou d'autres valeurs (A") de grandeur de sortie, des équations différentielles étant transformées en un état stationnaire.

8. Système (1) suivant la revendication 7, comprenant un module (5) de simulation, qui est agencé pour simuler le processus de l'installation sur la base des valeurs (E) de grandeur d'entrée et/ou des valeurs (P) de paramètres et/ou d'autres valeurs (A") de grandeur de sortie déterminées (S4).

FIG 1

FIG 2

# FIG 3

100

S1

S2

S3

S4

**IN DER BESCHREIBUNG AUFGEFÜHRTE DOKUMENTE**

*Diese Liste der vom Anmelder aufgeführten Dokumente wurde ausschließlich zur Information des Lesers aufgenommen und ist nicht Bestandteil des europäischen Patentdokumentes. Sie wurde mit größter Sorgfalt zusammengestellt; das EPA übernimmt jedoch keinerlei Haftung für etwaige Fehler oder Auslassungen.*

**In der Beschreibung aufgeführte Patentdokumente**

- EP 3521947 A1